Europäisches Patentamt

European Patent Office

Office européen des brevets

(11) Publication number: **0 064 590**
**B1**

## EUROPEAN PATENT SPECIFICATION

(45) Date of publication of patent specification: **25.09.85**

(21) Application number: **82102506.1**

(22) Date of filing: **25.03.82**

(51) Int. Cl.⁴: **H 03 K 23/50,** H 03 K 21/12

(54) High speed binary counter.

(30) Priority: **04.05.81 US 259878**

(43) Date of publication of application:
**17.11.82 Bulletin 82/46**

(45) Publication of the grant of the patent:
**25.09.85 Bulletin 85/39**

(84) Designated Contracting States:
**DE FR GB IT**

(56) References cited:
**EP-A-0 017 091**
**US-A-3 515 341**
**US-A-3 588 461**

(73) Proprietor: **International Business Machines
Corporation
Old Orchard Road
Armonk, N.Y. 10504 (US)**

(72) Inventor: **DasGupta, Sumit
5 Drew Court
Wappingers Falls New York 12590 (US)**

(74) Representative: **Kindermann, Manfred
Schönaicher Strasse 220
D-7030 Böblingen (DE)**

## Description

The present invention relates to a binary counter and more particularly to the reduction in the number of logic circuits used in binary counters.

A binary counter can be considered as a string of trigger stages driven one after the other by an input signal whose frequency is divided by two as it is used to drive each sequentially higher order trigger stage in the string. The division of the frequency of the input signal for any given stage can be accomplished by ANDing the clock input signal to the counter with the outputs of all the lower order stages. This arrangement requires frequency divider driver for each shift register stage. The number of AND computations that must be performed by a frequency divider driver increases geometrically with the number of shift register stages in the string. Therefore it is very desirable to find a means by which the number of such drivers can be reduced.

A prior art counter comprises two pairs of bistable circuits each of which counts in accordance with the principles of a Gray code (USA patent 3 515 341). Both pairs are connected by circuit means to advance the second pair in response to each completion of two Gray count cycles of the first pair of bistable circuits. A set of output gates connected to the outputs of the bistable circuits of both pairs generate counter output pulses in a 1-of-n-counting code. The circuit concept of this counter is not applicable to a counter circuit which comprises a large number of count stages. In addition, it does not provide output signals in a binary code.

There is another prior art Gray counter comprising a number of bistable circuits linked together by a plurality of sequentially connected gate circuits. Each of the bistable circuits is connected via one of its outputs to an Exclusive OR circuit for converting the Gray code count output to a binary code count output (USA patent 3 588 461). The second input of each Exclusive OR means is connected to the Exclusive OR means output of the next higher stage. The high sequential dependency between the stages of this counter reduces its operation speed.

The invention solves the problem of reducing the number of drivers in binary counters by disclosing a new high speed binary counter circuit using a pseudo Gray code counting scheme.

According to the invention, the problem is solved by the features characterized in claim 1. Advantageous embodiments and modifications of the invention are included in the subclaims.

Subsequently, one way of carrying out the invention is described by reference to the drawings of which:

Figure 1 is a diagram showing a counter incorporating the present invention,

Figure 2 is a block diagram of one stage of the two stage Gray code counter, and

Figure 3 is a table showing the counting sequence in a four stage pseudo Gray code counter and the desired binary counting sequence.

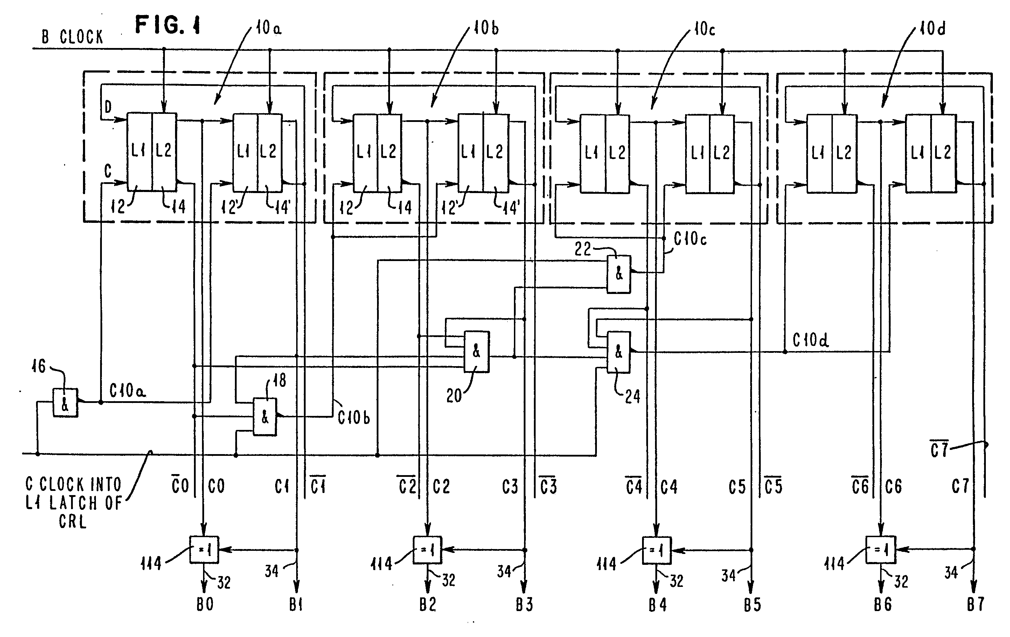

Referring to Figure 1, four two stage Gray code counters $10_a$, $10_b$, $10_c$, $10_d$ are shown connected together so as to produce a 2N digit pseudo Gray code count $C_0$, $C_1$, $C_2$,..., $C_7$.

Each of the two stage Gray counters is designated herein also as a Gray code counter unit including a first stage 12, 14 and a second stage 12', 14'. Each of these stages consists of a first half-stage 12 or 12' represented by a latch L1 and of a second half-stage 14 or 14' represented by a latch L2.

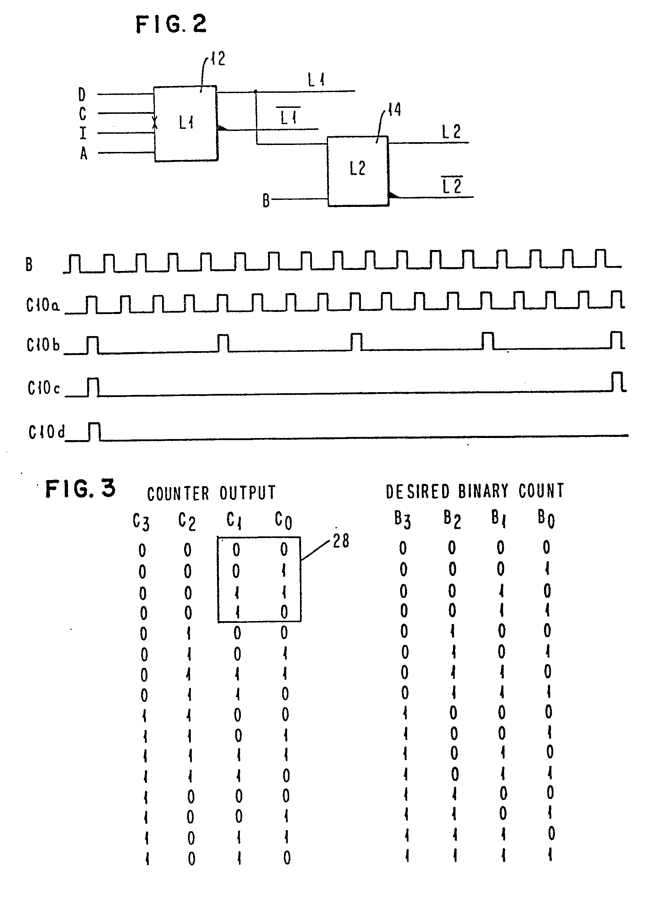

As shown in Figure 2, the first latch L1 in all stages receives the clock input signal on input terminal C. It is a timing pulse. The second latch L2 of each stage receives the output of the first latch L1 plus a second timing pulse B. The timing pulses C and B occur at mutually exclusive times with the pulse C occurring first so that a data bit entered into latch L1 during C time will be entered into latch L2 in B time. Latches of the type described here are known as shift register latches (SRLs) and are well known in the prior art. A detailed description of a SRL suitable for use in the present invention can be found in U.S. Patent 3 783 254, E. B. Eichelberger, "Level Sensitive Logic System", January 1, 1974.

The timing pulse B is fed to all the two bit Gray code counters $10_a$ to $10_d$ at the same frequency while the frequency of the timing pulse C varies depending on which Gray code counter it is fed to. The clock $C_{10a}$ is fed to the two lowest order stages of the shift register thru AND gate 16, of which only one input is used, at the frequency of the timing pulse C which is the same as the timing pulse B. The third and fourth order stages receive a clock pulse $C_{10b}$ at one fourth that frequency through AND gate 18 because of the ANDing the time pulse $C_{10a}$ with the outputs of the two lower order stages $10_a$. The clock pulse $C_{10c}$ fed to the stages $10_c$ of the third Gray code counter is one-fourth the frequency of the clock pulse $C_{10b}$ fed to the two stages $10_b$ of the second Gray code counter as a result of ANDing with the outputs of all the lower order stages in AND circuit 20 and 22. The AND connection of the outputs of the two lower order stages $10_a$, $10_b$ is performed by AND circuit 20 the output of which is fed to AND circuit 22. The clock $C_{10d}$ to the fourth Gray code counter is one-fourth the frequency of clock $C_{12c}$ as a result of ANDing in AND circuit 24 the outputs of the stages $10_c$ and of the AND circuit 20.

In each Gray code counter 10, the complemented output of its last stage 14 is fed into the data input D of its first stage 12 along with the clock pulse $C_{10}$ while the true output of the first stage is fed to the data input D of the second stage along with the clock pulse $C_{10}$. Application of clock pulses $C_{10}$ to the first Gray code counter $10_a$ produces a true Gray code sequence of pulses at $10_a$ and at the outputs $C_0$ and $C_1$ as is shown within box 28 of Figure 3. This is true of each of the Gray code counter stages 10, taken separately. However, when a plurality of two stage Gray code counter stages are joined together, the count of the resultant N stage counter violates the Gray code sequence. For example, when the count sequence overflows from 0010 to 0100 it violates the Gray code counting sequence. Therefore, the count of the counter is referred to as a pseudo Gray code count. A comparison of this pseudo Gray code count with the binary counting sequence shown in the righthand table of Figure 3 will show that the odd subscripted bits in both counts are identical while each even subscripted bit in the binary count is the Exclusive OR of that even subscripted bit in the Gray code count with the next higher odd subscripted bit in the Gray code count. Or more succinctly:

$B_i = C_i$ for odd i's
$= C_i \oplus C_{i+1}$ for even i's.

where

$B_i$ = any binary bit position
$C_i$ = any pseudo Gray code bit position.

The relationship expressed holds for an N digit count.

Therefore, the binary count bits $B_0$ to $B_7$ can be generated from the pseudo Gray code count bits $C_0$ to $C_7$ by using the odd subscripted bit count $C_1$, $C_3$,..., $C_7$ of the Gray code counter as the odd subscripted bits in the binary count and by using the result of the Exclusive ORing of any even subscripted bit count of the Gray code counter with the next higher odd scripted bit of that counter as the even subscripted bits in the binary count. The Exclusive ORing is performed by the Exclusive OR circuits 114 each connected to the true outputs of the pairs of stages $10_a$, $10_b$, $10_c$, $10_d$, respectively. The even subscripted binary outputs $B_0$, $B_2$, $B_4$ and $B_6$ of the counter shown in Fig. 1 are received on lines 32 each connected to the output of one of the Exclusive OR circuits 114. The odd subscripted binary outputs $B_1$, $B_3$, $B_5$ and $B_7$ are received on lines 34 each connected to the true output of the second stage 14 of one of the pairs of stages $10_a$, $10_b$, $10_c$ and $10_d$.

## Claims

1. A binary counter comprising a plurality 2N of bistable count stages grouped to Gray code counter units ($10_a$ to $10_d$) each consisting of a pair of bistable count stages (12, 14 and 12', 14') capable of generating a two bit Gray code count, further comprising circuit means coupling the Gray code counter units together for generating a multi digit pseudo Gray code count $C_0$, $C_1$,... $C_{2N-1}$, characterized by AND gate means (16, 18, 20, 22, 24) providing to both stages (12, 14 and 12', 14') in each Gray code counter unit ($10_a$ to $10_d$) a common clock pulse (for example, $C_{10c}$) whereby the AND gate means (for example, 20, 22) ANDs the outputs of the stages (12, 14, and 12', 14') of the Gray code counter units of lower order together with a first timing pulse (C), N Exclusive OR means (114) for Exclusive ORing the outputs of the respective pairs of bistable count stages comprising the N Gray code counter units

($10_a$ to $10_d$) together and, binary output means (32, 34) for generating a 2N digit binary count $B_0$, $B_1$,... $B_{2N-1}$ including means for using the outputs of the respective second stages (12', 14') of the Gray code counter units ($10_a$ to $10_d$) as the bits $B_1$, $B_3$, $B_5$,... $B_{2N-1}$ in the binary count and the output of the Exclusive OR circuits (114) as the bits $B_0$, $B_2$, $B_4$,... $B_{2N-2}$ in binary count whereby the pseudo Gray code count is converted to a binary count.

2. The binary counter of claim 1, characterized in that the count of the first stage (12, 14) of each Gray code counter unit ($10_a$ to $10_d$) is the input to the second stage (12', 14') of the same Gray code counter unit and the complement output of the second stage (12', 14') of each Gray code counter unit is the input to the first stage (12, 14) of the same Gray code counter unit.

3. The binary counter of claim 2, characterized in that each stage (12, 14 or 12', 14') of every Gray code counter unit ($10_a$ to $10_d$) includes two latches (L1, L2), each forming a half-stage, with the output of the first latch functioning as the input to the second latch, clocking means (B, C) for each latch for entering data into that latch said clocking means for said first latch (L1) being said clocking pulse (for example, $C_{10b}$) and the clocking means of said second latch (L2) being a timing pulse (B) which does not overlap said clock pulse.

## Patentansprüche

1. Binärzähler mit einer Anzahl 2N von bistabilen Zählstufen, welche in Gray-Code-Zählereinheiten ($10_a$ bis $10_d$) angeordnet sind und jeweils aus einem Paar bistabiler Zählstufen (12, 14 und 12', 14') bestehen, die eine Zweibit-Gray-Code-Zählung erstellen können, und mit einer Schaltung, welche die Gray-Code-Zählereinheiten zusammenschaltet zur Erstellung einer vielstelligen Pseudo-Gray-Code-Zählung $C_0$, $C_1$ ... $C_{2N-1}$, gekennzeichnet durch UND-Torschaltungen (16, 18, 20, 22, 24), die für beide Stufen (12, 14 und 12', 14') in jeder Gray-Code-Zählereinheit ($10_a$ bis $10_d$) einen gemeinsamen Taktimpuls (z.B. $C_{10c}$) liefern, wobei die UND-Torschaltungen (z.B. 20, 22) die Ausgänge der Stufen (12, 14 und 12', 14') der Gray-Code-Zählereinheiten niedrigerer Ordnung in einer UND-Schaltung mit einem ersten Zeitgeberimpuls (C) verbinden, durch N Exklusiv-ODER-Schaltungen (114), um die Ausgänge der entsprechenden bistabilen Zählerstufenpaare mit den N-Gray-Code-Zählereinheiten ($10_a$ bis $10_d$) in einer Exklusiv-ODER-Schaltung zu verbinden, und durch binäre Ausgänge (32, 34) zur Erzeugung einer 2N-stelligen Binärzählung $B_0$, $B_1$,... $B_{2N-1}$, die Mitteln zur Benutzung der Ausgänge der entsprechenden zweiten Stufen (12', 14') der Gray-Code-Zählereinheiten ($10_a$ bis $10_d$) als Bits $B_1$, $B_3$, $B_5$,... $B_{2N-1}$ in der binären Zählung und zur Benutzung des Ausgangs der Exklusiv-ODER-Schaltungen (114) als Bits $B_0$, $B_2$, $B_4$,... $B_{2N-2}$ in binärer Zählung, wodurch die Pseudo-Gray-Code-Zählung in eine binäre Zählung umgewandelt wird.

2. Binärzähler nach Anspruch 1, dadurch gekennzeichnet, daß die Zählung der ersten Stufe (12, 14) jeder Gray-Code-Zählereinheit ($10_a$ bis $10_d$) der Eingang zur zweiten Stufe (12′, 14′) derselben Gray-Code-Zählereinheit ist, und daß der komplementäre Ausgang der zweiten Stufe (12′, 14′) jeder Gray-Code-Zählereinheit der Eingang zur ersten Stufe (12, 14) derselben Gray-Code-Zählereinheit ist.

3. Binärzähler nach Anspruch 2, dadurch gekennzeichnet, daß jede Stufe (12, 14 oder 12′, 14′) jeder Gray-Code-Zählereinheit ($10_a$ bis $10_d$) zwei Verriegelungsschaltungen (L1, L2) enthält, die jede eine Halbstufe darstellen, wobei der Ausgang der ersten Verriegelungsschaltung als der Eingang zur zweiten Verriegelungsschaltung fungiert, mit Taktierungsmitteln (B, C) für jede Verriegelungsschaltung zur Eingabe von Daten in diese Verriegelungsschaltung, wobei die Taktierung für die erste Verriegelungsschaltung (L1) durch den Taktierungsimpuls (z.B. $C_{10b}$) vorgenommen wird und wobei die Taktierung der zweiten Verriegelungsschaltung (L2) durch einen Zeitgeberimpuls (B) vorgenommen wird, welcher den Taktierungsimpuls nicht überlagert.

**Revendications**

1. Un compteur binaire comprenant une pluralité (2N) d'étages de comptage bistables groupés en unités de comptage en code Gray ($10_a$ à $10_d$) se composant chacune d'une paire d'étages de comptage bistables (12, 14, et 12′, 14′) capables de produire un compte en code Gray à deux bits, comprenant en outre des circuits reliant ensemble les unités de comptage en code Gray pour engendrer un compte en pseudo-code Gray à chiffres multiples $C_0$, $C_1$... $C_{2N-1}$, caractérisé en ce qu'il est prévu des portes ET (16, 18, 20, 22, 24) appliquant aux deux étages (12, 14 et 12′, 14′) de chaque unité de comptage en code Gray ($10_a$ à $10_d$) une impulsion d'horloge commune (par exemple $C_{10c}$), de manière que les portes ET (par exemple 20, 22) assurent la combinaison logique ET des signaux de sortie des étages (12, 14 et 12′, 14′) des unités de comptage en code Gray d'ordre inférieur avec un première impulsion de cadencement (C), N portes OU Exclusif (114) pour assurer la combinaison logique OU Exclusif des signaux de sortie des paires respectives d'étages de comptage bistables comprenant les N unités de comptage en code Gray ($10_a$ à $10_d$) ainsi que des moyens de sortie binaire (32, 34) pour engendrer un compte binaire de 2 N chiffres $B_0$, $B_1$,... $B_{2N-1}$ comprenant des moyens pour utiliser les signaux de sortie des seconds étages respectifs (12′, 14′) des unités de comptage en code Gray ($10_a$ à $10_d$) comme les bits $B_1$, $B_3$, $B_5$,... $B_{2N-1}$ dans le compte binaire et les signaux de sortie des circuits OU Exclusif (114) comme les bits $B_0$, $B_2$, $B_4$,... $B_{2N-2}$ dans le compte binaire de façon que le compte en pseudo-code Gray soit converti en un compte binaire.

2. Le compteur binaire de la revendication 1, caractérisé en ce que le compte du premier étage (12, 14) de chaque unité de comptage en code Gray ($10_a$ à $10_d$) est le signal d'entrée au second étage (12′, 14′) de la même unité de comptage en code Gray et le signal de sortie en complémentation du second étage (12′, 14′) de chaque unité de comptage en code Gray est le signal d'entrée au premier étage (12, 14) de la même unité de comptage en code Gray.

3. Le compteur binaire de la revendication 2, caractérisé en ce que chaque étage (12, 14 ou 12′, 14′) de chaque unité de comptage en code Gray ($10_a$ à $10_d$) comprend deux verroux (L1, L2) formant chacun un demi-étage, le signal de sortie du premier verrou constituant le signal d'entrée au second verrou, un moyen de synchronisation (B, C) de chaque verrou pour l'introduction d'une donnée dans ce verrou), ledit moyen de synchronisation du premier verrou (L1) étant ladite impulsion d'horloge (par exemple $C_{10b}$) et le moyen de synchronisation du second verrou (L2) étant une impulsion de cadencement (B) qui ne chevauche pas ladite impulsion d'horloge.

FIG. 1

# FIG. 2

# FIG. 3

| COUNTER OUTPUT | | | | DESIRED BINARY COUNT | | | |
|---|---|---|---|---|---|---|---|
| $C_3$ | $C_2$ | $C_1$ | $C_0$ | $B_3$ | $B_2$ | $B_1$ | $B_0$ |
| 0 | 0 | 0 | 0 | 0 | 0 | 0 | 0 |
| 0 | 0 | 0 | 1 | 0 | 0 | 0 | 1 |
| 0 | 0 | 1 | 1 | 0 | 0 | 1 | 0 |
| 0 | 0 | 1 | 0 | 0 | 0 | 1 | 1 |
| 0 | 1 | 0 | 0 | 0 | 1 | 0 | 0 |
| 0 | 1 | 0 | 1 | 0 | 1 | 0 | 1 |
| 0 | 1 | 1 | 1 | 0 | 1 | 1 | 0 |
| 0 | 1 | 1 | 0 | 0 | 1 | 1 | 1 |
| 1 | 1 | 0 | 0 | 1 | 0 | 0 | 0 |
| 1 | 1 | 0 | 1 | 1 | 0 | 0 | 1 |
| 1 | 1 | 1 | 1 | 1 | 0 | 1 | 0 |
| 1 | 1 | 1 | 0 | 1 | 0 | 1 | 1 |
| 1 | 0 | 0 | 0 | 1 | 1 | 0 | 0 |
| 1 | 0 | 0 | 1 | 1 | 1 | 0 | 1 |
| 1 | 0 | 1 | 1 | 1 | 1 | 1 | 0 |
| 1 | 0 | 1 | 0 | 1 | 1 | 1 | 1 |